## Europäisches Patentamt
## European Patent Office
## Office européen des brevets

(19)

(11) Numéro de publication : **0 001 030**
**B1**

(12)

# FASCICULE DE BREVET EUROPÉEN

(45) Date de publication du fascicule du brevet :
**19.05.82**

(51) Int. Cl.³ : **H 01 L 21/00, G 03 F 7/02, G 03 F 7/20**

(21) Numéro de dépôt : **78430002.2**

(22) Date de dépôt : **22.06.78**

(54) Procédé de fabrication d'un masque selon une configuration donnée sur un support.

(30) Priorité : **30.06.77 US 811757**

(43) Date de publication de la demande :
**07.03.79 (Bulletin 79/05)**

(45) Mention de la délivrance du brevet :
**19.05.82 Bulletin 82/20**

(84) Etats contractants désignés :
**DE FR GB**

(56) Documents cités :
**FR - A - 2 236 336**
**FR - A - 2 310 633**
**US - A - 3 971 860**

**SOLID STATE TECHNOLOGY, vol. 20, nr. 5, mai 1977, New York, USA**
**G.P. HUGHES « X-ray lithography for IC processing », pages 39-42**

(73) Titulaire : **International Business Machines Corporation**
**Armonk, N.Y. 10504 (US)**

(72) Inventeur : **Chang, Tai Hon Philip**
**30 Pont Hill Road**
**Chappaqua New York 10514 (US)**

(74) Mandataire : **Klein, Daniel**
**COMPAGNIE IBM FRANCE Département de Propriété Industrielle**
**F-06610 La Gaude (FR)**

Imprimerie Jouve, 18, rue St-Denis, 75001 Paris, France

Procédé de fabrication d'un masque selon une configuration donnée sur un support.

Description

Domaine de l'invention

La présente invention concerne un procédé de formation de masques selon une configuration désirée et, plus particulièrement, l'exposition d'un premier matériau sensible à un faisceau d'électrons suivie de l'exposition d'un deuxième matériau sensible à une énergie électromagnétique de préférence des rayons X ou des rayons ultraviolets de courte longueur d'onde (rayons ultraviolets lointains), en vue de former un masque composite desdits matériaux pour la réalisation de dispositifs intégrés à semi-conducteurs.

Etat de la technique antérieure

La publication US-A-3 849 136 décrit la façon dont est utilisé un masque d'aluminium pour la couche d'un matériau photorésistant de type actinique sous-jacente. Dans ce brevet un substrat est revêtu par deux couches de matériau photorésistant de type AZ-1350H (Shipley), qui sont séparées par une couche d'aluminium déposée par évaporation, le matériau résistant sous-jacent étant maintenu à la température ambiante. La couche supérieure est également faite dans un matériau résistant actinique et est exposée selon une configuration désirée au moyen d'un masque classique, pour être ensuite développée. Puis, des ouvertures sont réalisées dans la couche d'aluminium au travers des ouvertures ainsi faites dans le masque photorésistant supérieur. Toute la couche de matériau photorésistant supérieure restante et les portions de la couche de matériau résistant inférieur exposées grâce à l'étape de décapage précédente sont alors surexposées, puis développées pour réaliser le décapage latéral du matériau résistant sous-jacent au masque métallique, ce dernier présente donc un surplomb dans toutes les ouvertures. Enfin, toute la structure du masque est supprimée par un procédé d'élimination par soulèvement.

Une technique voisine prévoyant la formation d'un photomasque in situ est décrite dans la publication FR-A-2 236 336.

La publication US-A-3 873 361 décrit le dépôt d'une couche photorésistante sensible à la lumière actinique, à base d'un polymère organique, qui est cuite jusqu'à ce qu'elle ne soit plus photosensible (par exemple, une couche de bakélite). Puis, on procède au dépôt d'une couche d'un matériau inorganique, de préférence métallique, choisi de préférence parmi les matériaux suivants : cuivre, aluminium, chrome, verre, $Si_3N_4$ et $Al_2O_3$. Cette étape est suivie par le dépôt d'une couche supérieure faite dans un matériau photorésistant actinique qui est exposée au travers d'un masque puis développée. Le métal est décapé chimiquement uniquement au travers des nouvelles ouvertures faites dans le matériau photorésistant supérieur. Le masque métallique ainsi formé est alors utilisé comme masque pour la couche de matériau résistant inférieure déjà durcie, qui est supprimée par décapage, afin que la couche métallique présente des surplombs dans les ouvertures au travers desquelles un mince film métallique est évaporé. Enfin, toute la structure du masque est supprimée par un procédé d'élimination par soulèvement.

Un exemple du procédé d'élimination par soulèvement est décrit dans l'article intitulé « Two-Resist Layers Lift-Off Process » paru dans la revue IBM Technical Disclosure Bulletin, Vol. 16, n° 7, décembre 1973, pages 2110-2111. Cette technique permet d'éviter le recours à un système d'exposition par faisceau d'électrons, en utilisant l'exposition, de deux couches de matériau résistant sensible aux rayons actiniques, faites séparément plutôt que d'utiliser un matériau résistant unique sensible aux électrons, on fait alors appel à une couche métallique intermédiaire (Cr) qui joue le rôle de masque, avant de procéder aux étapes de dépôt à travers les ouvertures faites dans le masque métallique, et d'élimination par soulèvement. Il est à noter que l'exposition au travers du masque métallique se fait en utilisant un angle d'incidence variable, à l'aide, par exemple d'un prisme rotatif.

D'après la publication US-A-3 447 924 une pièce de travail revêtue sur les deux côtés, d'abord d'un matériau photorésistant de type négatif sensible aux rayons actiniques du spectre visible et, ensuite, d'une émulsion sensible aux rayons X. Les rayons X sont appliqués sur un premier côté mais apparaissent également de l'autre côté de sorte que l'image sera développée sur les deux côtés, découvrant partiellement sur les deux côtés le matériau photorésistant sensible à la lumière visible. Le matériau photorésistant ainsi découvert est ensuite exposé sur les deux côtés, puis tout le matériau résistant aux rayons X est supprimé. Le matériau photorésistant est alors développé et le matériau résistant non exposé est éliminé. Enfin, la pièce de travail est décapée à travers le matériau photorésistant restant sur les deux côtés.

La publication US-A-3 874 916 décrit un substrat de verre successivement revêtu d'un mince film de chrome et d'un matériau résistant sensible aux faisceaux d'électrons. Ensuite, on applique un mince film de métal conducteur, par exemple, de l'aluminium. Sur ce métal conducteur on applique un mince film de matériau photorésistant sensible aux rayons actiniques. Le matériau photorésistant est exposé au travers d'un masque principal (grille) avant d'être développé. La couche conductrice qui est ensuite mise à nu par le développement du matériau photorésistant, est décapée à travers les ouvertures faites dans le matériau photorésistant. Enfin, le matériau résistant sensible aux électrons peut être exposé par le balayage d'un faisceau d'électrons sous la commande d'un calculateur.

La publication US-A-3 679 497 décrit l'exposition d'un matériau résistant sensible aux électrons à partir d'un faisceau d'électrons émis par une photocathode faite dans un matériau transparent à la lumière ultraviolette (par exemple du quartz) ; cette photocathode est revêtue d'un métal selon une configuration appropriée, qui émet un faisceau d'électrons en réponse à l'application de ces rayons ultraviolets. Le matériau résistant exposé est ensuite développé pour faire des trous aux emplacements désirés. Ensuite, des couches de matériau résistant sensible aux électrons peuvent être ajoutées et une photocathode distincte peut être employée pour chaque couche de matériau résistant sensible aux électrons. Cependant, chaque couche de matériau résistant est exposée et développée avant l'application de la couche suivante.

Aucun des procédés de l'art antérieur n'offre la possibilité d'utiliser un système d'exposition à faisceau d'électrons, commandé par calculateur, ni obtenir les excellents rapports géométriques assurés au moyen des techniques d'exposition aux rayons actiniques, de préférence les techniques d'exposition aux rayons X et aux rayons ultraviolets (rayons ultraviolets lointains) qui fournissent des parois latérales rectilignes et abruptes.

Exposé de l'invention

Un premier objet de la présente invention réside dans un procédé de production de masques utilisables dans des procédés de fabrication de films minces permettant l'emploi de matériaux sensibles différents, par exemple, un matériau sensible aux électrons et un matériau sensible aux rayons actiniques.

Un autre objet de l'invention réside dans un procédé de production de masques permettant l'emploi de couches de matériaux identiques, du type sensible aux électrons en utilisant la capacité de l'électron lithographie, de jouer sur l'énergie du faisceau pour sensibiliser sélectivement une couche.

Un autre objet de l'invention réside dans un procédé de production de masque dans lequel la couche métallique intermédiaire classique peut être omise, ou si elle est utilisée, elle peut être très mince, donc assurant une excellente résolution, en outre son élimination est facile.

Un autre objet de la présente invention est de réaliser dans un masque de matériau sensible déposé sous forme de film mince, des ouvertures qui présentent des parois latérales abruptes sans décapage latéral, et en outre d'assurer que les différents masques, utilisés lors de la fabrication des dispositifs semi-conducteurs, soient parfaitement alignés les uns avec les autres, grâce aux possibilités de l'alignement automatiques offertes par l'électron-lithographie.

La présente invention dans un concept inventif le plus général a pour objet un procédé de fabrication d'un masque selon une configuration désirée sur un support, du genre comprenant :
— le dépôt sur ce support d'une première couche d'un premier matériau sensible à un premier rayonnement,
— la formation in situ d'une couche de masquage selon une configuration désirée sur la première couche et
— l'exposition de la première couche à un rayonnement actinique à travers la couche de masquage et son développement,
caractérisé en ce que :
— ladite étape de formation comprend le dépôt d'une seconde couche d'un second matériau sensible aux électrons et son exposition à un faisceau d'électrons dont l'énergie est telle que ladite première couche n'est pas exposée.

Cette étape de formation peut comprendre la formation d'un mince film métallique soit par un procédé soustractif, soit par un procédé additif.

Dans un mode de réalisation, le procédé comporte le dépôt d'une première couche de matériau résistant sensible aux rayons électromagnétiques actiniques, sur un support. Puis, une couche d'un matériau résistant sensible aux électrons, est appliquée sur le matériau résistant aux rayons actiniques. Le matériau résistant sensible aux électrons est ensuite exposé à un faisceau d'électrons utilisé selon une configuration prédéterminée, et est ensuite développé. Cette configuration de masquage est ensuite employée pour former une configuration correspondante soit dans la première couche, soit dans un film mince métallique recouvrant la première couche. Dans ce dernier cas, le film métallique a été préalablement déposé sur la première couche avant la couche sensible aux électrons, le mince film métallique étant employé à son tour comme masque afin d'exposer la première couche de matériau résistant sensible au rayonnement actinique. La première couche de matériau résistant est ensuite développée.

De façon préférée, le matériau résistant inférieur sera exposé par application de rayons ultravolets lointains ou de rayons X.

Par définition, on entendra par rayonnement actinique, tel qu'il est employé ici, tout rayonnement électromagnétique, ayant une longueur d'onde comprise entre 0,1 et 5 000 Å environ ce qui inclut l'application des rayons X, ou de rayons optiques, et les rayons ultraviolets lointains, par opposition au rayonnement produit par les faisceaux d'électrons.

Selon un autre mode de réalisation de la présente invention, les couches de matériau résistant supérieure et inférieure peuvent être réalisées à partir d'un matériau résistant identique ou similaire et dans ce cas l'exposition du matériau résistant supérieur se fait avec un niveau d'énergie tel que la couche inférieure de matériau résistant ne soit pas exposée, et que la couche métallique, (si elle est intercalée dans les couches résistantes), protège la couche inférieure du matériau résistant. Cet aspect de la présente invention convient particulièrement bien dans le cas où le film métallique est formé par le procédé soustractif et dans le cas où ledit matériau résistant est sensible aux électrons.

D'autres objets, caractéristiques et avantages de la présente invention ressortiront mieux de l'exposé qui suit, fait en référence aux dessins annexés à ce texte, qui représentent un mode de réalisation préféré de celle-ci.

Brève description des dessins

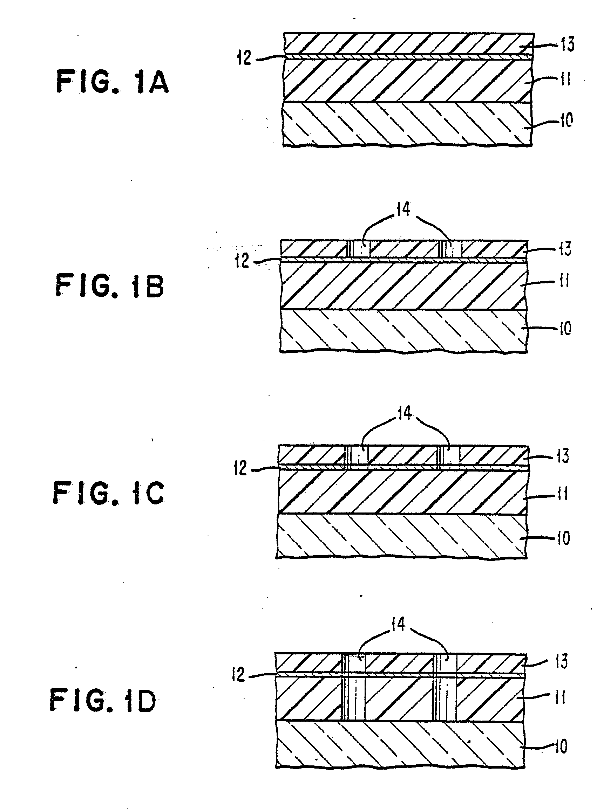

La figure 1A représente un support recouvert successivement par une couche inférieure de matériau résistant positif sensible aux rayons actiniques, un film métallique mince, et une couche supérieure de matériau résistant sensible aux électrons.

La figure 1B représente la structure représentée sur la figure 1A après que la couche supérieure de matériau résistant ait été exposée au moyen d'un faisceau d'électrons, et développée.

La figure 1C représente la structure représentée sur la figure 1B après que la couche métallique ait été décapée à travers les ouvertures pratiquées dans la couche supérieure.

La figure 1D représente la structure représentée sur la figure 1C après l'application des rayons actiniques qui a pour objet d'exposer la couche inférieure avec un rapport géométrique élevé qui assurera le rapport géométrique élevé désiré de la structure après développement.

Les figures 1A et 1D représentent un premier mode de réalisation qui met en œuvre des techniques dites soustractives pour délimiter la couche métallique selon la configuration désirée.

La figure 2A représente un support revêtu successivement par une couche inférieure de matériau résistant sensible aux rayons actiniques et une couche supérieure de matériau résistant aux électrons.

La figure 2B représente la structure représentée sur la figure 2A après balayage par un faisceau d'électrons de la couche de matériau résistant supérieur et développement.

La figure 2C représente la structure représentée sur la figure 2B après le dépôt d'un mince film métallique.

La figure 2D représente la structure représentée sur la figure 2C après suppression du matériau résistant restant ce qui élimine simultanément le métal et ce qui aboutit finalement à un masque métallique semblable à celui de la figure 1C, dont la couche de matériau résistant supérieur n'aurait pas été représentée.

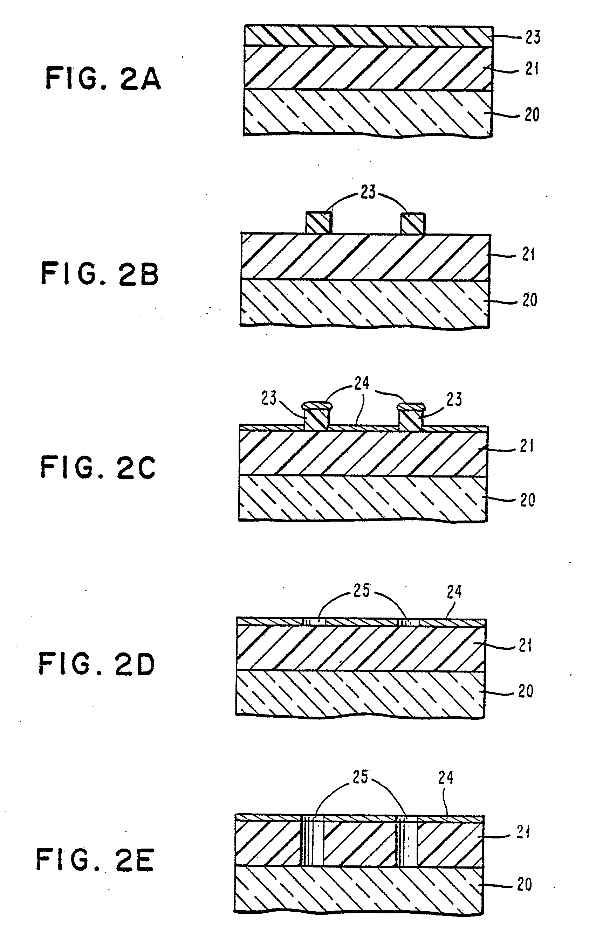

Les figures 2A à 2E représentent un deuxième mode de réalisation qui met en œuvre des techniques dites « additives » pour délimiter la couche métallique selon la configuration désirée.

La figure 2E représente la structure représentée sur la figure 2D après exposition du matériau résistant supérieur aux rayons actiniques et développement, pour réaliser des trous présentant un rapport géométrique élevé dans la couche de matériau résistant inférieur.

Description des modes de réalisation préférés de la présente invention Sur la figure 1A, un support 10, qui peut être le substrat d'une tranche de semi-conducteur ou un support de masque, est revêtu d'une couche d'un matériau résistant 11 sensible aux rayons X et aux rayons lumineux sur une gamme de longueur d'onde comprise entre 0,1 et 5 000 Å. L'épaisseur du matériau résistant 11 est présélectionnée conformément à l'épaisseur requise pour fournir le rapport géométrique requis dans la configuration finale du produit comme un rapport hauteur-largeur d'une ligne conductrice ou de masquage.

Ensuite, un mince film 12 d'un métal tel que l'aluminium, l'or ou le chrome, est déposé sur le matériau résistant 11. Le film 12 doit servir de masque intermédiaire pour les longueurs d'onde auxquelles est sensible le matériau résistant 11. Le choix de son épaisseur dépend de la technique d'exposition spécifique employée. Par exemple, lorsque le film 12 est soumis à des rayons X (gamme de longueur d'onde de 8 à 10 Å), il doit avoir une épaisseur de plusieurs milliers d'angströms dans le cas de l'or, ou même plus, selon une loi qui est une fonction inverse de la longueur d'onde. Ainsi, dans le cas du chrome ou de l'aluminium lorsque le film 12 est soumis à des rayons optiques, il doit avoir une épaisseur de plusieurs centaines d'angströms tandis que, pour une exposition aux rayons ultraviolets, son épaisseur doit être alors de quelques milliers d'angströms dans la gamme des longueurs d'onde comprises entre 2 000 et 5 000 Å.

Au-dessus du film 12, une couche de matériau résistant 13, de préférence du type positif, sensible aux électrons, par exemple du polyméthyl-méthacrylate (ou polyméthacrylate de méthyle) PMMA, ou un copolymère de méthyl-méthacrylate et d'acide méthacrylique [P (MMA/MAA)] désigné ci-après comme un matériau résistant copolymère, est déposée, par exemple, sur une épaisseur de plusieurs milliers d'angströms.

La figure 1B représente le matériau résistant 13 dans lequel on a pratiqué des trous ou ouvertures selon une configuration désirée 14 par exposition à un faisceau électronique classique de la couche de matériau peut également être obtenue par des techniques de projection.

La figure 1C montre la structure résultante après élimination du film métallique 12, aux emplacements des trous faits dans la couche de matériau résistant 13, à l'aide d'une technique quelconque, par exemple un décapage chimique liquide, un décapage par des ions réactifs ou un usinage ionique. Etant donné que le film 12 n'a, habituellement, qu'une épaisseur de l'ordre du millier d'angströms, l'épaisseur de la couche de matériau résistant 13 alors nécessaire pour protéger le film 12 de tout produit décapant, gaz de décapage ou ions, est relativement faible. Par voie de conséquence, un rapport géométrique élevé n'est pas nécessaire, dans ce cas d'une mince couche 12, le procédé de décapage n'attaquera pas le matériau résistant à des emplacements non désirés étant donné qu'un décapage léger suffit pour enlever la mince couche de métal.

La figure 1D représente la structure obtenue après que la structure montrée sur la figure 1C ait été exposée à des rayons X ou à l'action de photons dans la gamme de sensibilité du matériau résistant 11. Les portions du matériau résistant 11 se trouvant en dessous des trous 14 sont donc exposées puis développées, afin d'exposer le support 10 qui peut être le substrat d'une tranche semi-conductrice ou une plaque de masque sur laquelle peuvent être formées des structures diverses. Le support 10 peut être décapé à travers cette structure ou bien le masque peut être utilisé à l'occasion d'un procédé par soulèvement ou de placage, d'autres applications peuvent être également envisagées. Le matériau résistant 11 doit être peu sensible à la forme de rayonnement employée pour exposer le matériau résistant 13, ce qui ne l'empêche pas éventuellement d'être sensible à ce rayonnement. Le faisceau d'électrons pénètre dans le matériau sur une épaisseur de plusieurs microns. Cependant, le film métallique 12 bloque le développement de la couche de matériau résistant inférieure même si elle est exposée au faisceau d'électrons. L'énergie du faisceau électronique peut être réglée à un niveau tel que les électrons sont bloqués par le film métallique 12. L'intensité du faisceau d'électrons est suffisamment faible pour éviter que les couches de matériau résistant 13 et 11 et le film métallique 12 ne fusionnent ou ne s'évaporent. L'intensité requise pour exposer le matériau résistant sans le surchauffer est bien connue de l'homme de l'art et va varier d'un matériau résistant à un autre. Un exemple de matériau résistant sensible à un faisceau d'électrons est le PMMA, mentionné ci-dessus.

La figure 2A représente un support 20 revêtu d'un matériau résistant de type positif 21 sensible aux rayons actiniques (gamme allant du spectre visible aux rayons X), lui-même revêtu d'un matériau résistant sensible aux électrons 23, par exemple, le matériau résistant de type copolymère cité ci-dessus. Le révélateur utilisé pour la couche supérieure (par exemple ledit copolymère) ne doit pas attaquer de façon sensible le matériau résistant inférieur, qui peut être dans certaines applications du PMMA.

La figure 2B représente la structure après l'exposition et le développement du matériau résistant 23 sensible aux électrons, avec de préférence un décapage latéral (ou affouillement) qui permet l'utilisation d'un procédé par soulèvement, comme cela est bien connu dans le domaine de l'exposition par faisceaux d'électrons.

Sur la figure 2C, un mince film d'un métal, choisi par exemple parmi Al, Cr ou Au, est déposé sur la structure montrée sur la figure 2B, qui laisse apparaître des structures en forme de champignon à capuchons métalliques. Puis, un solvant est appliqué pour supprimer le matériau résistant restant et les capuchons métalliques ce qui fait que les structures en forme de champignon sont supprimées, comme le montre la figure 2D, afin de laisser des trous 25 dans le film métallique 24. On trouve une structure très voisine de celle représentée sur la figure 1C.

Puis, les rayons (ou radiations) actiniques sont appliqués à travers les ouvertures 25, à la couche 21 afin de l'exposer après développement comme le montre la figure 2E on obtient des trous à rapport géométrique élevé, mis en évidence dans le cas présent au moyen du procédé additif.

Il s'est avéré que les rayons X ou les rayons ultra-violets lointains sur le matériau résistant inférieur ne sont que très faiblement réfléchis, c'est ce qui assure un rapport géométrique très élevé.

La technique s'appuyant sur l'application d'un faisceau d'électrons a comme avantage de fournir une résolution et une souplesse élevées, en outre les configurations peuvent être écrites sous la commande directe d'un calculateur sans avoir recours à un masque. Cependant, cette technique n'assure que difficilement un rapport géométrique (c'est-à-dire un rapport hauteur-largeur de ligne) très élevé dans la configuration exposée, et ce, par suite du rebondissement dû à la réflexion du faisceau d'électrons. En pratique, dépasser un rapport géométrique de 1, est très difficile. Par ailleurs, dans le cas de techniques d'exposition à des rayons X ou à des rayons ultraviolets (classiques et lointains), il n'est pas possible d'obtenir une écriture directe sous la commande d'un calculateur alors qu'un rapport géométrique élevé peut en général être plus facilement obtenu. Par exemple, des configurations exposées aux rayons X ont montré des rapports géométriques dépassant 10. La présente invention s'appuie sur une nouvelle technique qui combine avantageusement les bénéfices d'une écriture directe grâce à une exposition à un faisceau d'électrons et l'obtention d'un rapport géométrique élevé grâce à l'exposition à des rayons X ou à des rayons optiques ou ultraviolets.

La mise en œuvre du premier mode de réalisation préféré du procédé soustractif ci-dessus en référence aux figures 1A à 1D peut se concevoir de la façon résumée suivante :

Etape 1, Préparation de l'échantillon (Figure 1A)

L'échantillon (tranche semi-conductrice ou plaque de masquage) est tout d'abord revêtu d'une couche de matériau résistant sensible à un rayonnement actinique. L'épaisseur de cette couche va être déterminée par le rapport géométrique requis dans la configuration finale.

Un mince film métallique, par exemple de l'aluminium, de l'or ou du chrome, est ensuite déposé sur la couche de matériau résistant. Ce film, dans la suite, va servir de masque lors de l'étape d'exposition audit rayonnement, et le choix du métal et de son épaisseur va alors dépendre de la technique d'exposition spécifique qui sera utilisée. Enfin, une couche de matériau résistant sensible aux électrons est déposée sur le film mince. La préparation de l'échantillon est ainsi réalisée.

Etape 2, Exposition à un faisceau d'électrons (Figure 1B)

Le faisceau d'électrons est utilisé pour exposer la couche de matériau résistant supérieure, selon la configuration requise. Après exposition le matériau résistant est développé.

Etape 3, Décapage du masque (Figure 1C)

Le film métallique est décapé selon la configuration de masque définie par la couche restante de matériau résistant supérieure. Plusieurs techniques de décapage peuvent être utilisées, par exemple, le décapage chimique, le décapage par ions réactifs et l'usinage ionique. Etant donné que le film métallique est, de façon générale, mince (quelques milliers d'angströms), l'épaisseur requise de la couche supérieure pour supporter ce décapage, n'a pas à être grande. En conséquence, il n'est pas nécessaire que la configuration ait un rapport géométrique élevé.

Etape 4, Exposition au rayonnement actinique (Figure 1D)

L'exposition aux rayons actiniques (du spectre visible aux rayons X durs) est utilisée pour exposer la couche résistante inférieure au travers du masque ainsi créé. Après exposition, le matériau résistant peut être développé de la manière classique pour réaliser la configuration finale présentant le rapport géométrique élevé souhaité.

Cette technique offre donc la possibilité d'obtenir des configurations à résolution élevée avec faculté d'écriture directe par calculateur. En outre, l'alignement avec une configuration de recouvrement peut facilement être assuré en utilisant un système d'alignement automatique par faisceaux électroniques. En outre, les matériaux constitutifs de la couche résistante supérieure pour résister au procédé d'attaque, sont très nombreux. Ils incluent des matériaux résistants négatifs de très grande sensibilité qui conviennent particulièrement bien à l'application de faisceaux d'électrons à vitesse élevée.

**Revendications**

1. Procédé de fabrication d'un masque selon une configuration désirée sur un support (10, 20), du genre comprenant : le dépôt sur ce support (10, 20) d'une première couche (11, 21) d'un premier matériau sensible à un premier rayonnement, la formation in situ d'une couche de masquage selon une configuration désirée sur la première couche et l'exposition de la première couche à un rayonnement actinique à travers la couche de masquage et son développement, caractérisé en ce que :

ladite étape de formation comprend le dépôt d'une seconde couche (13, 23) d'un second matériau sensible aux électrons et son exposition à un faisceau d'électrons dont l'énergie est telle que ladite première couche (11, 21) n'est pas exposée.

2. Procédé de fabrication selon la revendication 1 caractérisé en ce que ladite étape de formation comprend le dépôt d'une mince couche de métal (12, 24), soit après l'exposition du second matériau et son développement (procédé dit additif) soit avant le dépôt du second matériau (procédé dit soustractif).

3. Procédé de fabrication selon la revendication 1 ou 2 caractérisé en ce que le premier matériau est sensible à un faisceau d'électrons.

4. Procédé de fabrication selon la revendication 1 ou 2 caractérisé en ce que le premier matériau est sensible aux rayons actiniques.

5. Procédé de fabrication selon la revendication 4 caractérisé en ce que le premier matériau est sensible aux rayons UV lointains et aux rayons X.

6. Procédé de fabrication selon la revendication 3 caractérisé en ce que le second matériau est du type négatif choisi dans le groupe comprenant le PMMA et le P [(MMA/MAA)].

7. Procédé de fabrication selon la revendication 3 caractérisé en ce que lesdits premier et second matériaux sont constitués par le PMMA.

8. Procédé de fabrication selon l'une des revendications 2 à 7 caractérisé en ce que le métal est choisi dans le groupe comprenant Au, Cr, et Al.

9. Procédé de fabrication selon l'une quelconque des revendications 1 à 8 caractérisé en ce que le support est choisi dans le groupe comprenant : un substrat semi-conducteur recouvert par une couche diélectrique et une plaque transparente destinée à servir de support de masque.

**Claims**

1. A method of forming a mask on a substrate (10, 20) according to a desired pattern, of the type which includes : depositing on said substrate (10, 20) a first layer (11, 21) made of a first material sensitive to a first radiation ; forming in situ a masking layer on the first layer according to a desired pattern, and exposing said first layer to an actinic radiation through the masking layer and developing said first layer ;

characterized in that :

said mask forming step includes depositing a second layer (13, 23) of a second material sensitive to the electrons and exposing said second layer to an electron beam with an energy such that said first layer (11, 21) is not exposed.

2. A method to claim 1, characterized in that said mask forming step includes depositing a thin metal layer (12, 24) either after exposure and development of the second material (the so-called additive method) or before of the second material (the so-called subtractive method).

3. A method according to claim 1 or claim 2, characterized in that the first material is sensitive to an electron beam.

4. A method according to claim 1 or claim 2,

characterized in that the first material is sensitive to actinic rays.

5. A method according to claim 4, characterized in that the first material is sensitive to deep UV-rays and to X-rays.

6. A method according to claim 3, characterized in that the second material is of the negative type selected from the group including PPMA and P [(MMA/MAA)].

7. A method according to claim 3, characterized in that said first and second materials are comprised of the PMMA.

8. A method according to any one of claims 2 through 7, characterized in that the metal is selected from the group including Au, Cr and Al.

9. A method according to any one of claims 1 through 8, characterized in that the substrate is selected from the group including a semiconductor substrate coated with a dielectric layer and a transparent plate used as the mask support.

## Ansprüche

1. Verfahren zum Herstellen einer Maske gemäß einer gewünschten Konfiguration auf einer Halterung (10, 20), bei dem auf diese Halterung (10, 20) eine erste Schicht (11, 21) aus einem ersten, gegenüber einer ersten Strahlung empfindlichen Stoff aufgebracht, in situ eine Maskierungsschicht gemäß einer gewünschten Konfiguration auf der ersten Schicht gebildet und die erste Schicht mittels einer aktinischen Strahlung durch die Maskierungsschicht hindurch bestrahlt und entwickelt wird,
dadurch gekennzeichnet,

daß bei dem genannten Verfahrensabschnitt eine zweite Schicht (13, 23) aus einem zweiten, gegenüber Elektronen empfindlichen Stoff aufgebracht und diese einem Elektronenstrahl, dessen Energie so eingestellt ist, daß die erste Schicht (11, 21) nicht bestrahlt wird, ausgesetzt wird.

2. Herstellungsverfahren gemäß Anspruch 1, dadurch gekennzeichnet, daß bei dem genannten Verfahrensabschnitt eine dünne Metallschicht (12, 24) aufgebracht wird, und zwar entweder nach der Bestrahlung des zweiten Stoffes und dessen Entwicklung (sogenanntes Additivverfahren) oder vor dem Aufbringen des zweiten Stoffes (sogenanntes Substraktivverfahren).

3. Herstellungsverfahren gemäß Anspruch 1 bzw. 2, dadurch gekennzeichnet, daß der erste Stoff empfindlich gegenüber Elektronenbestrahlung ist.

4. Herstellungsverfahren gemäß Anspruch 1 bzw. 2, dadurch gekennzeichnet, daß der erste Stoff empfindlich gegenüber aktinischer Bestrahlung ist.

5. Herstellungsverfahren gemäß Anspruch 4, dadurch gekennzeichnet, daß der erste Stoff empfindlich gegenüber Strahlen der fernen UVs und Röntgenstrahlen ist.

6. Herstellungsverfahren gemäß Anspruch 3, dadurch gekennzeichnet, daß der zweite Stoff vom negativen Typ ist, der aus der Gruppe von PMMA und P(MMA/MAA) ausgewählt wird.

7. Herstellungsverfahren gemäß Anspruch 3, dadurch gekennzeichnet, daß der erste und der zweite Stoff aus PMMA bestehen.

8. Herstellungsverfahren gemäß einem der Ansprüche 2 bis 7, dadurch gekennzeichnet, daß das Metall aus der Gruppe ausgewählt wird, die Au, Cr und Al beinhaltet.

9. Herstellungsverfahren gemäß irgendeinem der Ansprüche 1 bis 8, dadurch gekennzeichnet, daß das Trägermaterial aus der Gruppe ausgewählt wird, die folgendes beinhaltet: ein halbleitendes Substrat mit einer nicht leitenden Schicht und einer durchsichtigen Platte, die als Träger für die Maske dient.

**FIG. 1A**

**FIG. 1B**

**FIG. 1C**

**FIG. 1D**

FIG. 2A

FIG. 2B

FIG. 2C

FIG. 2D

FIG. 2E